# EUROPEAN PATENT APPLICATION

(11) **EP 2 216 827 A1**
(43) Date of publication of application: **11.08.2010**
(21) Application number: 08847340.0
(22) Date of filing: 28.10.2008
(51) Int. Cl.: H01L 31/042

(54) **SOLAR BATTERY MODULE AND METHOD FOR MANUFACTURING SOLAR BATTERY MODULE**

(30) Priority: 09.11.2007 JP 2007291967
(71) Applicant: Sharp Kabushiki Kaisha, Osaka-shi Osaka 545-8522 (JP)
(72) Inventor: ABIKO, Yoshiya, Osaka 545-8522 (JP)
(74) Representative: Müller - Hoffmann & Partner
(86) International application number: PCT/JP2008/069511
(87) International publication number: WO 2009/060753

(57) **Abstract**

There is provided a solar cell module including: a wiring substrate (200) having a base material (111) and a wiring (109, 110) formed on the base material (111); and a solar cell (100) having an electrode (106, 107) electrically connected to the wiring (109, 110) of the wiring substrate (200), the wiring (109, 110) being electrically connected to the electrode (106, 107) by bringing the wiring (109, 110) into direct contact with the electrode (106, 107). There is also provided a method for manufacturing the solar cell module.

## Description

### TECHNTCAL FIELD

The present invention relates to a solar cell module and a method for manufacturing a solar cell module. In particular, the present invention relates to a solar cell module that can be readily manufactured at a low temperature and has excellent electrical properties and reliability, and a method for manufacturing the solar cell module.

### BACKGROUND ART

In recent years, it has been desired to develop clean energy because of global environmental problems and the like such as exhaustion of energy resources and an increase in CO₂ in the atmosphere. In particular, the photovoltaic power generation using a solar cell module has been developed, put to practical use and is progressing as a new energy source.

As a solar cell that configures such a solar cell module, a double-sided electrode type solar cell, for example, has been conventionally a mainstream, in which a p-n junction is formed by diffusing impurities whose conductivity type is opposite to that of a monocrystalline or polycrystalline silicon substrate, over a light receiving surface of the silicon substrate, and electrodes are formed on the light receiving surface of the silicon substrate and a back surface opposite to the light receiving surface, respectively. In addition, the development of a so-called back electrode type solar cell has been advanced in recent years, in which an electrode for the p type and an electrode for the n type are both formed on a back surface of a silicon substrate.

In addition, the thickness of the silicon substrate has also been reduced in order to reduce the cost of raw materials. There arises a problem, however, that reduction in the thickness of the solar cell due to reduction in the thickness of the silicon substrate results in a crack in the solar cell during the operation of wiring the solar cells when the solar cell module is fabricated.

In order to solve such a problem, a method for wiring solar cells by using a wiring substrate is proposed in, for example, Japanese Patent Laying-Open No. 2005-340362 (Patent Document 1). According to such a method in Patent Document 1, enhancement of an F. F (Fill Factor) value of a solar cell module is also expected. Here, the wiring substrate is configured to include a base material and a wiring formed on the base material.

Although the use of the wiring substrate to connect the solar cells is proposed as described above, it is not yet in practical use. This is because of the following problems.

First, when common lead-free cream solder (such as Sn-Ag-Cu-based solder) is used to connect an electrode of the solar cell and the wiring of the wiring substrate, it is required to heat the solder to around 250°C.

When heating to a high temperature is required at the time of connecting the electrode of the solar cell and the wiring of the wiring substrate as described above, a stress is produced at the time of cooling after heating to the high temperature, due to a difference in thermal expansion coefficient between a silicon substrate of the solar cell and a wiring material of the wiring substrate. As a result, there is a problem that the reliability of the connection is reduced because of a crack in the solar cell, separation of the solar cell from the wiring substrate, or the like.

The above stress can be significantly reduced by lowering the heating temperature at the time of connecting the electrode of the solar cell and the wiring of the wiring substrate. When the above heating temperature is set to 180°C or lower, PEN (polyethylene naphthalate) can be used as the base material of the wiring substrate, and when the above heating temperature is set to 150°C or lower, PET (polyethylene terephthalate) can be used as the base material of the wiring substrate. Therefore, the material cost can be significantly reduced.

The solder that can be treated at such a low temperature includes inexpensive Sn-Bi-based solder of low electrical resistance. There is a problem, however, that when the Sn-Bi-based solder is used to connect the electrode of the solar cell and the wiring of the wiring substrate, the adhesiveness between the electrode of the solar cell and the wiring of the wiring substrate becomes worse and reliability of the connection is not so high, as compared with the case where the solder such as the Sn-Ag-Cu-based solder other than the Sn-Bi-based solder is used.

In addition, when a conductive paste other than the solder is used instead of the solder to connect the electrode of the solar cell and the wiring of the wiring substrate, connection at room temperature is also possible. There is a problem, however, that it is difficult to use the conductive paste in the solar cell through which a large current flows, because most of the conductive pastes have a high resistivity. Moreover, the conductive paste containing silver as a main ingredient has a low resistivity of about 1×10⁻⁴ to 10⁻⁵ Ω●cm, and some conductive pastes allow connection at a low temperature of about 150°C. There is a problem, however, that such conductive pastes are very expensive and cannot achieve sufficient adhesion strength between the electrode of the solar cell and the wiring of the wiring substrate.

In addition, a method for placing an optical sensor formed of a solar cell on a substrate including a connection terminal by using an ACF (Anisotropic Conductive Film) is proposed in Japanese Patent Laying-Open No. 2005-175436 (Patent Document 2). This method also allows connection at a low temperature. There is a problem, however, that the use of the expensive ACF is difficult because it is required to use the large-area ACF when the solar cell is applied to a solar cell module for power generation, not to the optical sensor. Furthermore, there is a problem that the resistance becomes too high when the ACF is used in the solar cell module through which the large current needs to be passed.

Connection of the electrode of the solar cell and the wiring of the wiring substrate requires a step of applying the conductive paste, aligning and arranging the solar cell on the wiring substrate, and then, heating the solar cell by using a reflow furnace. There is a problem that this step is complicated as a step of manufacturing the solar cell module, and when the large-area solar cell is used, misalignment of the solar cell occurs at the time of heating by using the reflow furnace, which leads to the frequent occurrence of poor connection.
Patent Document 1: Japanese Patent Laying-Open No. 2005-340362
Patent Document 2: Japanese Patent Laying-Open No. 2005-175436

### DISCLOSURE OF THE INVENTION

### PROBLEMS TO BE SOLVED BY THE INVENTION

In view of the above circumstances, an object of the present invention is to provide a solar cell module that can be readily manufactured at a low temperature and has excellent electrical properties and reliability, and a method for manufacturing the solar cell module.

### MEANS FOR SOLVING THE PROBLEMS

The present invention is directed to a solar cell module, including: a wiring substrate having a base material and a wiring formed on the base material; and a solar cell having an electrode electrically connected to the wiring of the wiring substrate, the wiring being electrically connected to the electrode by bringing the wiring into direct contact with the electrode.

In the solar cell module of the present invention, a through hole penetrating from one surface to the other surface of the base material is preferably formed in the wiring substrate.

In addition, in the solar cell module of the present invention, the base material of the wiring substrate is preferably made of a transparent resin.

In addition, the solar cell module of the present invention may include a sealant sealing the wiring substrate and the solar cell. The sealant preferably includes at least one type of transparent resin selected from the group consisting of an ethylene vinyl acetate resin, an epoxy resin, an acrylic resin, a urethane resin, an olefin-based resin, a polyester resin, a silicone resin, a polystyrene resin, a polycarbonate resin, and a rubber-based resin.

In addition, in the solar cell module of the present invention, the solar cell is preferably a back electrode type solar cell.

In addition, in the solar cell module of the present invention, the solar cell and the wiring substrate are preferably fixed by a fixing member.

In addition, in the solar cell module of the present invention, the fixing member may couple a light receiving surface of the solar cell and a surface of the wiring substrate on a side where the solar cell is placed.

In addition, in the solar cell module of the present invention, the fixing member may couple a back surface of the solar cell and a surface of the wiring substrate on a side where the solar cell is placed.

In addition, in the solar cell module of the present invention, the fixing member is preferably at least one type selected from the group consisting of an adhesive tape, a viscous adhesive tape, an adhesive, and a viscous adhesive agent.

In addition, in the solar cell module of the present invention, the fixing member is preferably made of at least one of a transparent resin and an ultraviolet curing resin.

In addition, the present invention is directed to a solar cell module, including: a wiring substrate having a base material and a wiring formed on the base material; and a solar cell having an electrode electrically connected to the wiring of the wiring substrate, the wiring being electrically connected to the electrode by bringing the wiring into direct contact with the electrode, the solar cell module including a sealant sealing the wiring substrate and the solar cell, and the sealant being placed on only one surface of the solar cell and press-bonded to the solar cell to seal the wiring substrate and the solar cell.

In addition, the present invention is directed to a method for manufacturing the above solar cell module, including the steps of: placing the solar cell on the wiring substrate; press-bonding a first transparent resin placed on a surface of the solar cell opposite to a side where the wiring substrate is placed and a second transparent resin placed on a surface of the wiring substrate opposite to a side where the solar cell is placed; and heating the first transparent resin and the second transparent resin after the press-bonding.

In the method for manufacturing the solar cell module of the present invention, the first transparent resin and the second transparent resin are preferably press-bonded by vacuum press-bonding.

In addition, in the method for manufacturing the solar cell module of the present invention, a through hole penetrating from one surface to the other surface of the base material is preferably formed in the wiring substrate, and the through hole penetrating from one surface to the other surface of the second transparent resin is preferably formed in the second transparent resin.

Furthermore, the present invention is directed to a method for manufacturing the above solar cell module, including the steps of: placing the solar cell on the wiring substrate having the base material made of a transparent resin; press-bonding the base material of the wiring substrate and a first transparent resin placed on a surface of the solar cell opposite to a side where the wiring substrate is placed; and heating the base material and the first transparent resin after the press-bonding.

In addition, the method for manufacturing the solar cell module of the present invention preferably includes the step of fixing the solar cell and the wiring substrate by a fixing member.

In addition, in the method for manufacturing the solar cell module of the present invention, the fixing member is preferably placed to couple a light receiving surface of the solar cell and a surface of the wiring substrate on the side where the solar cell is placed.

In addition, in the method for manufacturing the solar cell module of the present invention, the fixing member is preferably placed to couple a back surface of the solar cell and a surface of the wiring substrate on the side where the solar cell is placed.

In addition, in the method for manufacturing the solar cell module of the present invention, the fixing member is preferably at least one type selected from the group consisting of an adhesive tape, a viscous adhesive tape, an adhesive, and a viscous adhesive agent.

In addition, in the method for manufacturing the solar cell module of the present invention, the fixing member is preferably made of at least one of the transparent resin and an ultraviolet curing resin.

### EFFECTS OF THE INVENTION

According to the present invention, there can be provided a solar cell module that can be readily manufactured at a low temperature and has excellent electrical properties and reliability, and a method for manufacturing the solar cell module.

### BRIEF DESCRIPTION OF THE DRAWINGS

Fig. 1 is a schematic cross-sectional view of an example of a solar cell used in a solar cell module of the present invention.
Fig. 2 is a schematic cross-sectional view of another example of the solar cell used in the solar cell module of the present invention.
Fig. 3 (a) is a schematic plan view of an example of a back surface of the solar cell used in the present invention, and Fig. 3(b) is a schematic plan view of another example of the back surface of the solar cell used in the present invention.
Fig. 4 is a schematic plan view of an example of a wiring substrate used in the present invention.
Fig. 5 is a schematic plan view of an example of a solar cell complex used in the present invention.
Fig. 6 is a schematic plan view of another example of the solar cell complex used in the present invention.
Fig. 7 is a schematic cross-sectional view of an example of the solar cell module of the present invention.
Figs. 8(a) and (b) are schematic cross-sectional views illustrating a manufacturing process of an example of a method for manufacturing the solar cell module of the present invention by using the solar cell that has a configuration shown in Fig. 1.
Figs. 9(a) and (b) are schematic cross-sectional views illustrating a manufacturing process of an example of the method for manufacturing the solar cell module of the present invention by using the solar cell that has a configuration shown in Fig. 2.
Figs. 10(a) and (b) are schematic cross-sectional views illustrating a manufacturing process of another example of the method for manufacturing the solar cell module of the present invention.
Figs. 11(a) to (c) are schematic cross-sectional views illustrating a manufacturing process of still another example of the method for manufacturing the solar cell module of the present invention.
Figs. 12(a) and (b) are schematic cross-sectional views illustrating a manufacturing process of another example of the method for manufacturing the solar cell module of the present invention by using the solar cell that has the configuration shown in Fig. 1.

### DESCRIPTION OF THE REFERENCE SIGNS

100 solar cell; 101 silicon substrate; 102 antireflection film; 103 passivation film; 104 n-type impurities-doped region; 105 p-type impurities-doped region; 106 n electrode; 107 p electrode; 109 wiring for the n type; 110 wiring for the p type; 111 insulating substrate; 113 connecting electrode; 114 bus bar p electrode; 115 bus bar n electrode; 116 conductive member; 124 transparent substrate; 125 sealant; 125a first transparent resin; 125b second transparent resin; 126 insulating film; 127 metal film; 128 protective sheet; 130, 131 through hole; 200 wiring substrate; 300 fixing tape

### BEST MODES FOR CARRYING OUT THE INVENTION

Embodiments of the present invention will be described hereinafter. In the drawings of the present invention, the same reference characters denote the same or corresponding portions.

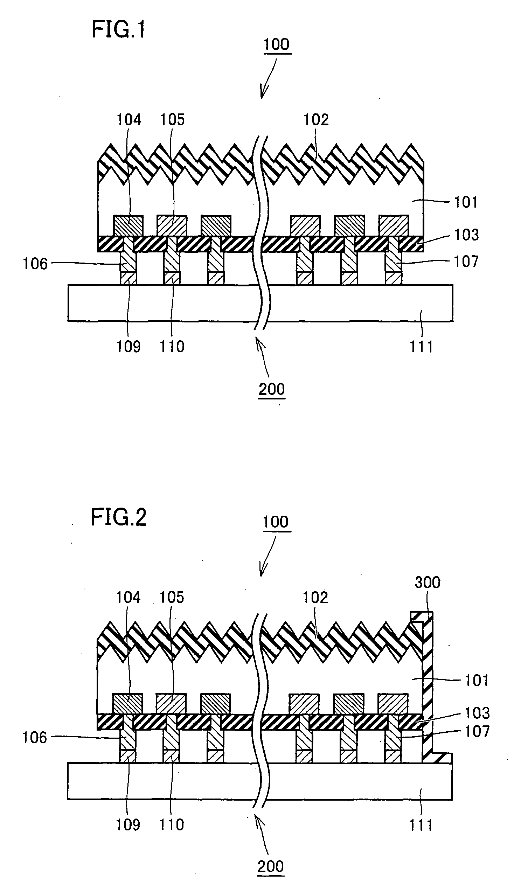

Fig. 1 shows a schematic cross-sectional view of an example of a solar cell used in a solar cell module of the present invention. The solar cell shown in Fig. 1 has a wiring substrate 200 and a solar cell 100 placed on wiring substrate 200. An antireflection film 102 is formed on a light receiving surface (a surface on the side on which solar light mainly falls) of an n-type or p-type silicon substrate 101 of solar cell 100. An n-type impurities-doped region 104 formed by diffusing n-type impurities and a p-type impurities-doped region 105 formed by diffusing p-type impurities are alternately formed at a prescribed spacing on a back surface (a surface opposite to the light receiving surface) of silicon substrate 101.

In addition, a passivation film 103 is formed on the back surface of silicon substrate 101. Through a contact hole formed in passivation film 103, an n electrode 106 is formed to come into contact with n-type impurities-doped region 104, and a p electrode 107 is formed to come into contact with p-type impurities-doped region 105.

In addition, wiring substrate 200 has an insulating substrate 111 serving as a base material, and a wiring for the n type 109 and a wiring for the p type 110 serving as wirings formed on insulating substrate 111.

N electrode 106 of solar cell 100 is electrically connected to wiring for the n type 109 of wiring substrate 200, and p electrode 107 is electrically connected to wiring for the p type 110 of wiring substrate 200.

The solar cell shown in Fig. 1 has a configuration in which n electrode 106 of solar cell 100 comes into direct contact with wiring for the n type 109 of wiring substrate 200 and p electrode 107 of solar cell 100 comes into direct contact with wiring for the p type 110 of wiring substrate 200.

Fig. 2 shows a schematic cross-sectional view of another example of the solar cell used in the solar cell module of the present invention. The solar cell shown in Fig. 2 includes a fixing tape 300 for fixing solar cell 100 to wiring substrate 200. Fixing tape 300 has one end attached to the light receiving surface of solar cell 100, and the other end attached to a surface of insulating substrate 111 of wiring substrate 200. Although a position where fixing tape 300 is attached is not particularly limited, fixing tape 300 is preferably attached to an end of the light receiving surface of solar cell 100 so as not to block the light receiving surface of solar cell 100 excessively.

A conventionally known tape can be used as fixing tape 300. An adhesive tape formed by applying an adhesive to an underlying base material such as a paper, a cloth or a resin film and/or a viscous adhesive tape formed by applying a viscous adhesive agent to the underlying base material such as a paper, a cloth or a resin film, and the like can be used. In particular, when at least a part of fixing tape 300 is placed on the light receiving surface of solar cell 100, it is preferable to use, as fixing tape 300, a tape formed by applying the viscous adhesive agent or the adhesive that passes at least a part of visible light (light having a wavelength ranging from 360 to 830 nm) to the underlying base material that passes at least a part of the visible light. It is noted that the adhesive tape that can be used in the present invention includes PET tape YT153S and the like produced by YOUNG WOO Co., Ltd., which is formed by applying a silicone-based adhesive to the underlying base material formed of, for example, a PET (polyethylene terephthalate) film. The viscous adhesive tape includes T4900, G9052 and the like produced by Sony Chemical Corporation, which is formed by applying an acrylic viscous adhesive agent to the underlying base material formed of, for example, the PET film.

In addition, instead of or together with fixing tape 300, the adhesive and/or the viscous adhesive agent may be applied to a region from the light receiving surface of solar cell 100 to a surface of wiring substrate 200 on the side where solar cell 100 is placed, for example.

It is noted that any adhesive can be used without particular limitation if the adhesive can affix solar cell 100 and wiring substrate 200 together, and an adhesive including at least one type selected from the group consisting of a high-heat-resistant silicone-based adhesive, an acrylic adhesive, an epoxy-based adhesive, and a rubber-based adhesive can be used, for example. Conventionally known adhesives, for example, can be used as the silicone-based adhesive, the acrylic adhesive, the epoxy-based adhesive, and the rubber-based adhesive, respectively. In addition, the viscous adhesive agent is a type of the adhesive, and is an agent which generally has viscosity, and which has fluidity with respect to an adherend through the application of pressure, and in which aggregation to separation produces retaining power in place of curing. It is noted that the adhesive that can be used in the present invention includes a thermosetting adhesive and the like such as Sealglo NE8800K produced by Fuji Chemical Industrial Co., Ltd.

In addition, instead of or together with fixing tape 300, at least one of a transparent resin and an ultraviolet curing resin may be applied to the region from the light receiving surface of solar cell 100 to the surface of wiring substrate 200 on the side where solar cell 100 is placed.

A conventionally known resin that is transparent to the solar light, for example, can be used as the transparent resin, and in particular, it is preferable to use the same material as that of a sealant that will be described below. In this case, the reactivity with the sealant is low enough that it is more likely to sufficiently suppress deterioration of the electrical properties of the solar cell module obtained by sealing with the sealant. It is noted that the transparent resin that can be used in the present invention includes, for example, a commercially available EVA (ethylene vinyl acetate) resin having a transmittance of 90% or more for the visible light, various types of acrylic curing resin, various types of epoxy-based curing resin, and the like.

A conventionally known resin that is cured by irradiation with ultraviolet light (light having a wavelength ranging from 1 to 400 nm), for example, can be used as the ultraviolet curing resin. In addition, a conventionally known additive such as a photopolymerization initiator and/or a photosensitizer may be added to the ultraviolet curing resin as required. It is noted that the ultraviolet curing resin that can be used in the present invention includes GL-1002 and the like produced by Gluelabo Ltd.

It is noted that, when a fluid fixing member such as the adhesive, the viscous adhesive agent, the transparent resin, and the ultraviolet curing resin is used as a fixing member for fixing solar cell 100 and wiring substrate 200, the fluid fixing member can be readily placed by using a technique of dripping the fluid fixing member from the light receiving surface side of solar cell 100, and the like. Therefore, the use of the fluid fixing member is preferable.

When the ultraviolet curing resin is used as the fixing member for fixing solar cell 100 and wiring substrate 200, misalignment of solar cell 100 with respect to wiring substrate 200 can be corrected before irradiation with the ultraviolet light, and after the absence of the misalignment is confirmed, ultraviolet irradiation can be provided to cure the ultraviolet curing resin to fix solar cell 100 and wiring substrate 200. Accordingly, when the ultraviolet curing resin is used as the fixing member, not only the accuracy of the position where solar cell 100 is placed on wiring substrate 200, but also handling after the ultraviolet curing resin is cured and the productivity of the solar cell module can be enhanced.

The configuration has been described in the above, in which the fixing member such as fixing tape 300 (the adhesive tape and/or the viscous adhesive tape and the like), the adhesive, the viscous adhesive agent, the transparent resin, and the ultraviolet curing resin couples the light receiving surface of solar cell 100 and the surface of wiring substrate 200 on the side where solar cell 100 is placed. Instead of or together with this configuration, a configuration may be employed, in which the fixing member such as fixing tape 300 (the adhesive tape and/or the viscous adhesive tape and the like), the adhesive, the viscous adhesive agent, the transparent resin, and the ultraviolet curing resin couples the back surface (the surface opposite to the light receiving surface of solar cell 100) of solar cell 100 and the surface of wiring substrate 200 on the side where solar cell 100 is placed.

In this case, from the viewpoint of ensuring the long-term reliability, the fluid fixing member that is used here such as the adhesive, the viscous adhesive agent, the transparent resin, and the ultraviolet curing resin is preferably a member that contracts appropriately and expresses contraction power between solar cell 100 and wiring substrate 200 at the time of curing. In addition, the fixing member such as the adhesive, the viscous adhesive agent, the transparent resin, and the ultraviolet curing resin is also preferably a thermosetting member that is cured at the time of sealing by heating the sealant that will be described below.

It is noted that, when the configuration is employed in which the fixing member couples the back surface of solar cell 100 and the surface of wiring substrate 200 on the side where solar cell 100 is placed, it is preferable to place the fixing member at a portion other than the wiring placed on the surface of wiring substrate 200 on the side where solar cell 100 is placed.

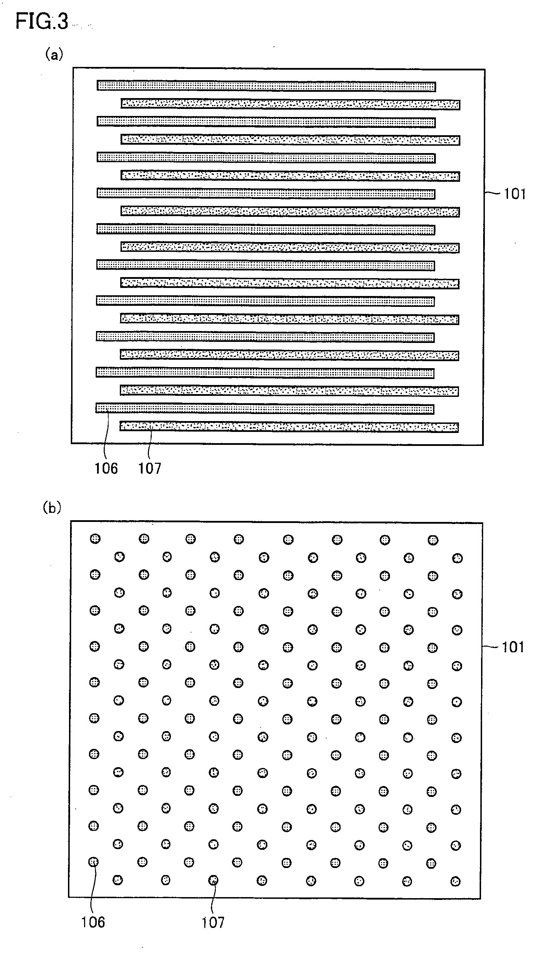

Fig. 3(a) shows a schematic plan view of an example of the back surface of the solar cell used in the present invention. N electrode 106 and p electrode 107 are formed on the back surface of silicon substrate 101, and each of n electrode 106 and p electrode 107 is formed in the shape of a strip that extends in the same direction (horizontal direction of the plane of Fig. 3(a)) on the back surface of silicon substrate 101. Strip-shaped n electrode 106 and strip-shaped p electrode 107 are alternately arranged one by one in the vertical direction of the plane of Fig. 3(a).

Fig. 3(b) shows a schematic plan view of another example of the back surface of the solar cell used in the present invention. N electrode 106 and p electrode 107 are formed on the back surface of silicon substrate 101, and each of n electrode 106 and p electrode 107 is formed in the shape of a dot. Dot-shaped n electrodes 106 are arranged adjacent to each other and dot-shaped p electrodes 107 are arranged adjacent to each other in the respective vertical and horizontal directions of the plane of Fig. 3(b).

By forming each of n electrode 106 and p electrode 107 on the back surface of the solar cell used in the present invention in the shape of the strip as shown in Fig. 3(a) and/or in the shape of the dot as shown in Fig. 3(b), it is more likely to suppress occurrence of bubbles between solar cell 100 and wiring substrate 200 after sealing into the sealant that will be described below. Therefore, the formation of each electrode in such shapes is preferable.

Each of n electrode 106 and p electrode 107 can be formed by using a method such as a vacuum deposition method, a sputtering method, a screen printing method, an ink jet method, a spray method, or a plating method. It is noted that wiring for the n type 109 and wiring for the p type 110 of wiring substrate 200 can bear most of the conductor resistance, and thus, the material usage in each of n electrode 106 and p electrode 107 can be considerably reduced. In addition, any material can be used as the material of n electrode 106 and p electrode 107 without particular limitation, if the material is a conductive material.

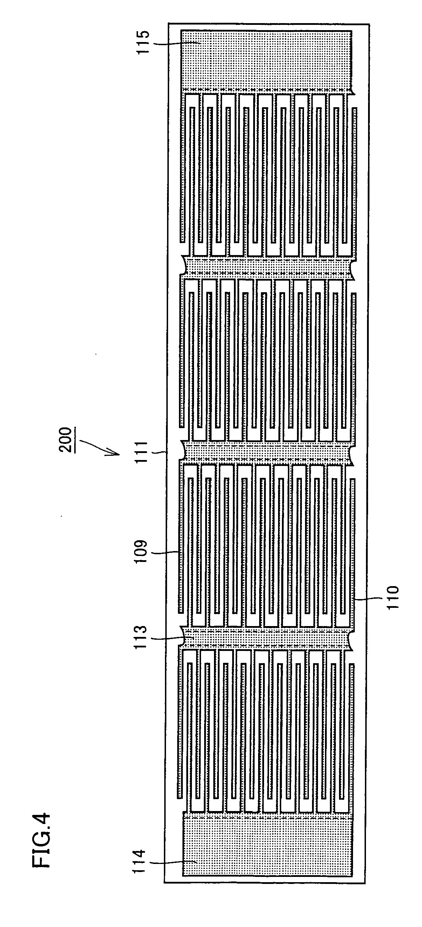

Fig. 4 shows a schematic plan view of an example of the wiring substrate used in the present invention. Wiring for the n type 109 and wiring for the p type 110 as well as a connecting electrode 113 for electrically connecting wiring for the n type 109 and wiring for the p type 110 are provided on the surface of insulating substrate 111 of wiring substrate 200.

A bus bar p electrode 114 for power collection is electrically connected to wiring for the p type 110 placed at one end in the longitudinal direction of insulating substrate 111. A bus bar n electrode 115 for power collection is electrically connected to wiring for the n type 109 placed at the other end.

It is noted that, although respective regions for wiring for the n type 109, wiring for the p type 110, connecting electrode 113, bus bar p electrode 114, and bus bar n electrode 115 are separated by a dashed line in Fig. 4, the present invention is not limited to the separation shown in Fig. 4.

For example, a substrate made of a material (for example, polyimide and the like having a heat resistance of 230°C or higher) having a higher electrical resistance than that of each of wiring for the n type 109 and wiring for the p type 110, and the like can be used as insulating substrate 111 used in wiring substrate 200. It is preferable, however, to use inexpensive and transparent PEN (polyethylene naphthalate) and/or PET (polyethylene terephthalate). When a substrate made of a transparent material such as PEN and PET is used as insulating substrate 111, alignment of the electrode of solar cell 100 and the wiring of wiring substrate 200 can be readily checked, and in automating the alignment, an alignment mark, for example, is formed on the back surface of solar cell 100 to allow the alignment with high accuracy.

Any material can be used, without particular limitation, as the material of wiring for the n type 109, wiring for the p type 110, connecting electrode 113, bus bar p electrode 114, and bus bar n electrode 115 used in wiring substrate 200, if the material is the conductive material such as a metal and a transparent conductive film. From the viewpoint of reducing the electrical resistance of the wiring, however, wiring for the n type 109, wiring for the p type 110, connecting electrode 113, bus bar p electrode 114, and bus bar n electrode 115 are preferably made of a material including at least one type selected from the group consisting of copper, aluminum and silver.

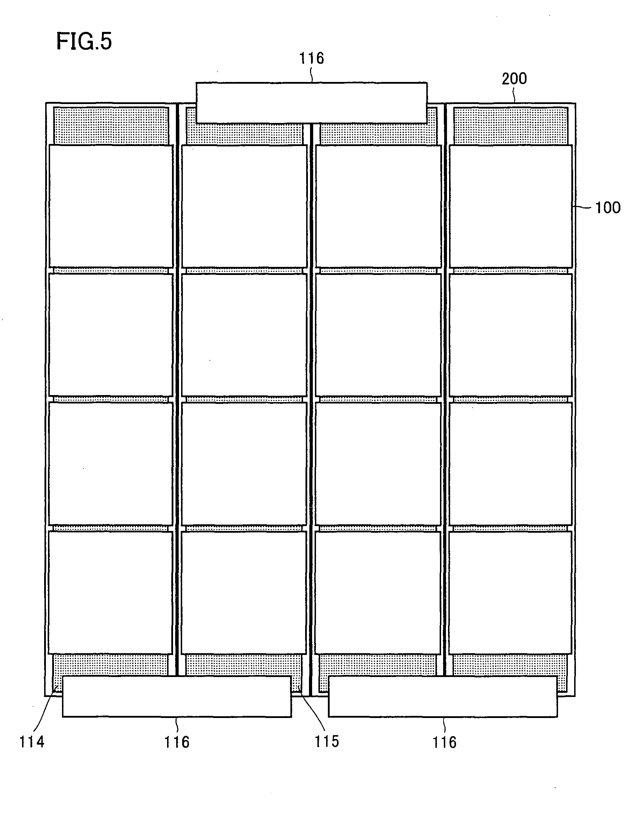

Fig. 5 shows a schematic plan view of an example of a solar cell complex formed by electrically connecting the solar battery in which a plurality of solar cells are electrically connected in series by placing the solar cells on the wiring substrate having the structure shown in Fig. 4.

In the solar cell complex shown in Fig. 5, in order to electrically connect adjacent two wiring substrates 200, a conductive member 116 electrically connects bus bar p electrode 114 of one wiring substrate 200 and bus bar n electrode 115 of the other wiring substrate 200.

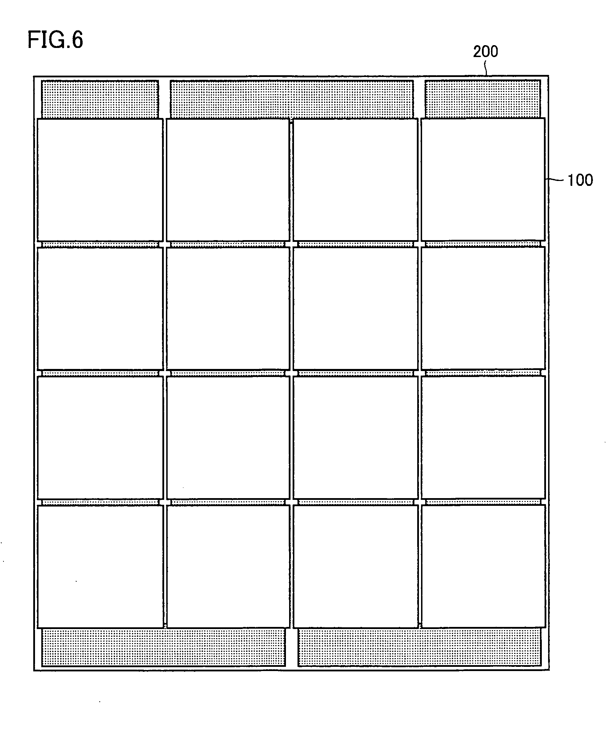

In addition, as in a solar cell complex shown in Fig. 6, for example, the solar cell complex may be configured such that the plurality of solar cells 100 are electrically connected in series naturally by placing solar cells 100 on wiring substrate 200, without using conductive member 116.

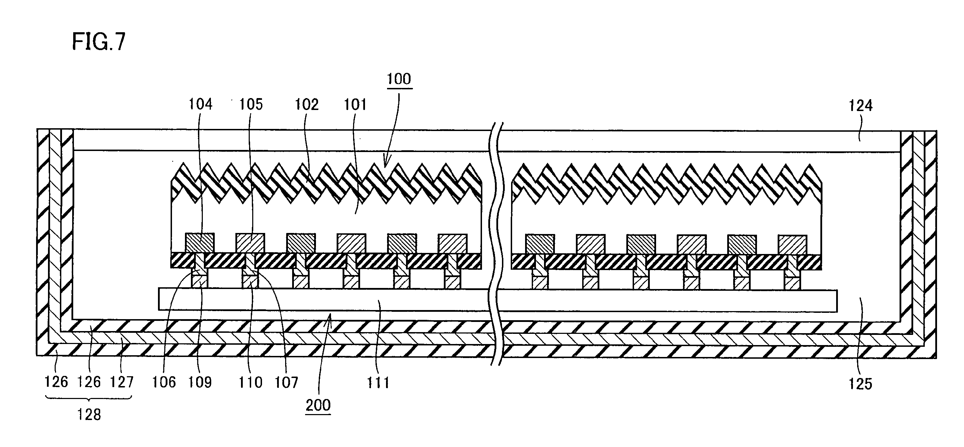

Fig. 7 shows a schematic cross-sectional view of an example of the solar cell module of the present invention fabricated by sealing the solar cell complex fabricated as described above into the sealant, for example. The solar battery in which solar cell 100 is placed on wiring substrate 200 is sealed into a sealant 125 housed by a protective sheet 128 that is formed by sandwiching a metal film 127 between two opposing insulating films 126. A transparent substrate 124 is placed on a surface of sealant 125.

A substrate that is transparent to the solar light, for example, can be used as transparent substrate 124 without particular limitation, and a glass substrate and the like can be used, for example.

In addition, a resin and the like that is transparent to the solar light, for example, can be used as sealant 125 without particular limitation. In particular, it is preferable to use, as sealant 125, at least one type of transparent resin selected from the group consisting of an ethylene vinyl acetate resin, an epoxy resin, an acrylic resin, a urethane resin, an olefin-based resin, a polyester resin, a silicone resin, a polystyrene resin, a polycarbonate resin, and a rubber-based resin. These transparent resins with excellent weather resistance have a high light permeability, and thus, can be secured with adequate strength to transparent substrate 124 formed of the glass substrate and the like, without significantly deteriorating the output (in particular, short-circuit current or current during operation) of the solar cell module. Therefore, these transparent resins can seal solar cell 100 while the long-term reliability of solar cell 100 is ensured.

In addition, a conventionally known film, for example, can be used as insulating film 126, and the PET film and the like can be used, for example.

In addition, a conventionally known film, for example, can be used as metal film 127. From the viewpoint of sufficiently suppressing permeation of water vapor and oxygen into sealant 125 and ensuring the long-term reliability, however, it is preferable to use a metal film such as aluminum. At a portion where it is difficult to bring protective sheet 128 into close contact, such as at an end face of the solar cell module, a moisture permeation prevention tape such as a butyl rubber tape can be used to bring protective sheet 128 into close contact completely. It is noted that a conventionally used weather-resistant film, for example, may be used as protective sheet 128.

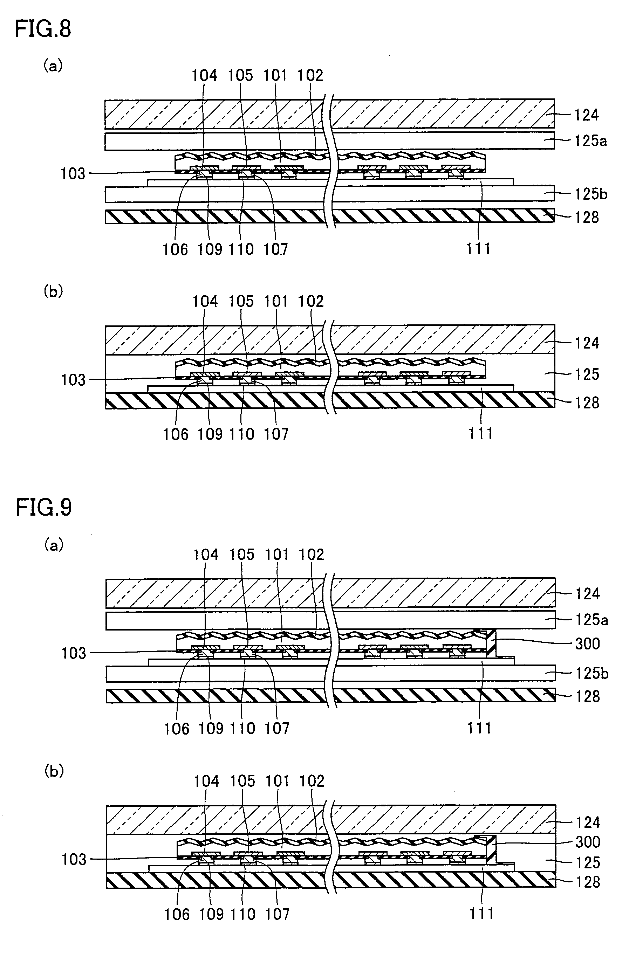

Figs. 8(a) and (b) show schematic cross-sectional views illustrating a manufacturing process of an example of a method for manufacturing the solar cell module of the present invention by using the solar cell that has the configuration shown in Fig. 1. First, as shown in Fig. 8(a), n electrode 106 of the solar cell is placed on wiring for the n type 109 formed on insulating substrate 111 serving as the base material of the wiring substrate, and p electrode 107 of the solar cell is placed on wiring for the p type 110, and thus, the solar cell is placed on the wiring substrate.

Next, a first transparent resin 125a including transparent substrate 124 is placed on the surface of the solar cell opposite to the side where the wiring substrate is placed. A second transparent resin 125b including protective sheet 128 is placed on the surface of the wiring substrate opposite to the side where the solar cell is placed. The same material as that of above sealant 125 can be used as a material of each of first transparent resin 125a and second transparent resin 125b.

Then, first transparent resin 125a and second transparent resin 125b are press-bonded and subjected to heat treatment. Thereby, first transparent resin 125a and second transparent resin 125b are cured in an integrated manner, and thus, sealant 125 is formed as shown in Fig. 8(b). As a result, the solar cell is strongly press-bonded to the wiring substrate, and the press-bonding between n electrode 106 of the solar cell and wiring for the n type 109 of the wiring substrate as well as the press-bonding between p electrode 107 of the solar cell and wiring for the p type 110 of the wiring substrate are each strengthened. Consequently, excellent electrical connection can be obtained between these electrodes and wirings. The solar battery in which the solar cell is placed on the wiring substrate is sealed into this sealant 125 as shown in Fig. 8(b), and thus, the solar cell module of the present invention is fabricated.

The press-bonding and heat treatment of first transparent resin 125a and second transparent resin 125b are performed by using, for example, a device, called a laminator, and the like for vacuum press-bonding and heat treatment. As a result, first transparent resin 125a and second transparent resin 125b are thermally deformed. These transparent resins are integrated as a result of thermal curing and the like to form sealant 125, and the solar cell is wrapped in and sealed into sealant 125.

It is noted that the vacuum press-bonding is a process of press-bonding under the atmosphere of a pressure lower than the atmospheric pressure. When the vacuum press-bonding is used as the method for press-bonding first transparent resin 125a and second transparent resin 125b, it is more likely that a void is not readily formed between first transparent resin 125a and second transparent resin 125b, and bubbles do not readily remain in sealant 125 formed as a result of integration of first transparent resin 125a and second transparent resin 125b. Therefore, the use of the vacuum press-bonding is preferable. In addition, the use of the vacuum press-bonding is advantageous in terms of ensuring the uniform press-bonding power between the solar cell and the wiring substrate.

In addition, when first transparent resin 125a and second transparent resin 125b are made of the ethylene vinyl acetate resin, the above heat treatment can be performed by heating these transparent resins to a temperature that is higher than or equal to 100°C and lower than or equal to 200°C, for example.

Figs. 9(a) and (b) show schematic cross-sectional views illustrating a manufacturing process of an example of the method for manufacturing the solar cell module of the present invention by using the solar cell that has the configuration shown in Fig. 2. This method is similar to the method shown in Figs. 8(a) and (b) except that the solar cell having the configuration shown in Fig. 2 in which fixing tape 300 is placed is used instead of the solar cell having the configuration shown in Fig. 1.

It is noted that fixing tape 300 is sealed into sealant 125 of the solar cell module as it is and may be seen from the light receiving surface side of the solar cell module in some cases. Accordingly, it is preferable to use a transparent tape as fixing tape 300, and furthermore, it is more preferable to use a tape having an excellent degree of close contact with sealant 125 or a tape made of a material that is integrated with sealant 125 after press-bonding and a material that is not subjected to degassing and the like during the manufacturing process and a weather-resistant material that is not changed in quality during practical use.

Although the case where fixing tape 300 is used as the fixing member is again described as in the above, the adhesive and/or the viscous adhesive agent may be applied to the region from the light receiving surface of solar cell 100 to the surface of wiring substrate 200 on the side where solar cell 100 is placed, instead of or together with fixing tape 300. Alternatively, at least one of the transparent resin and the ultraviolet curing resin may be applied to the region from the light receiving surface of solar cell 100 to the surface of wiring substrate 200 on the side where solar cell 100 is placed, instead of or together with fixing tape 300.

It is noted that, as described above, when the fluid fixing member such as the adhesive, the viscous adhesive agent, the transparent resin, and the ultraviolet curing resin is used as the fixing member for fixing solar cell 100 and wiring substrate 200, the fluid fixing member can be readily placed by using the technique of dripping the fluid fixing member from the light receiving surface side of solar cell 100, and the like. Therefore, the use of the fluid fixing member is preferable.

In addition, the configuration has been described in the above, in which the fixing member such as fixing tape 300 (the adhesive tape and/or the viscous adhesive tape and the like), the adhesive, the viscous adhesive agent, the transparent resin, and the ultraviolet curing resin couples the light receiving surface of solar cell 100 and the surface of wiring substrate 200 on the side where solar cell 100 is placed. Instead of or together with this configuration, the present invention may have the configuration in which the fixing member such as fixing tape 300 (the adhesive tape and/or the viscous adhesive tape and the like), the adhesive, the viscous adhesive agent, the transparent resin, and the ultraviolet curing resin couples the back surface (the surface opposite to the light receiving surface of solar cell 100) of solar cell 100 and the surface of wiring substrate 200 on the side where solar cell 100 is placed.

In addition, as described above, when the configuration is employed in which the fixing member couples the back surface of solar cell 100 and the surface of wiring substrate 200 on the side where solar cell 100 is placed, it is preferable to place the fixing member at the portion other than the wiring placed on the surface of wiring substrate 200 on the side where solar cell 100 is placed.

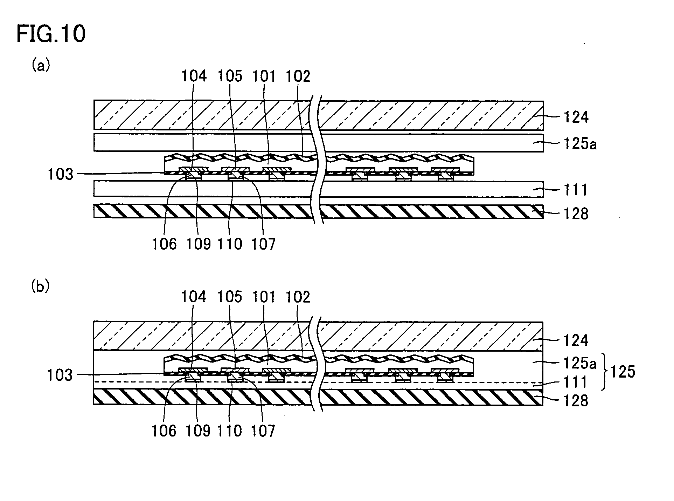

Figs. 10(a) and (b) show schematic cross-sectional views illustrating a manufacturing process of another example of the method for manufacturing the solar cell module of the present invention. In this method, instead of the solar cell having the configuration shown in Fig. 1, the solar cell is used, which is **characterized in that** the transparent resin is used as the material of insulating substrate 111 serving as the base material of the wiring substrate, and a part of sealant 125 functions as the base material of the wiring substrate, and the wiring is formed on the base material.

In this method, first, as shown in Fig. 10(a), n electrode 106 of the solar cell is placed on wiring for the n type 109 formed on insulating substrate 111 made of the transparent resin and serving as the base material of the wiring substrate, and p electrode 107 of the solar cell is placed on wiring for the p type 110, and thus, the solar cell is placed on the wiring substrate. Next, first transparent resin 125a including transparent substrate 124 is placed on the surface of the solar cell opposite to the side where the wiring substrate is placed.

Then, first transparent resin 125a and insulating substrate III are press-bonded, and then, subjected to heat treatment. Thereby, first transparent resin 125a and insulating substrate 111 are cured in an integrated manner, and first transparent resin 125a and insulating substrate 111 are integrated to form sealant 125 as shown in Fig. 10(b). As a result, a part of sealant 125 (a portion of the sealant located below the wiring substrate (a portion of insulating substrate 111)) serves as the base material of the wiring substrate, and the wiring is provided on the base material. Consequently, the solar cell module including the wiring substrate having the base material made of the transparent resin and the wiring on the base material is fabricated.

In this method, the number of the members used can be decreased, and thus, the operation efficiency in the process of manufacturing the solar cell module of the present invention can be enhanced and the material cost can be reduced.

In addition, in this method, in addition to the press-bonding power generated between the solar cell and the wiring substrate as a result of the formation of sealant 125, the press-bonding power as a result of the thermal deformation into a shape allowing the transparent resin that configures insulating substrate 111 to enter a space between n electrode 106 and p electrode 107 is generated. Therefore, it is more likely to further strengthen each of the press-bonding between n electrode 106 of the solar cell and wiring for the n type 109 of the wiring substrate as well as the press-bonding between p electrode 107 of the solar cell and wiring for the p type 110 of the wiring substrate, as compared with the above methods shown in Figs. 8 and 9. Accordingly, in this method, it is more likely to obtain more excellent electrical connection between the electrodes of the solar cell and the wirings of the wiring substrate, as compared with the above methods shown in Figs. 8 and 9. Therefore, this method is preferable.

In addition, in this method, from the viewpoint of enhancing the close contact power between first transparent resin 125a and insulating substrate 111 made of the transparent resin, it is preferable to use the same material for the transparent resin that configures insulating substrate 111 and the transparent resin that configures first transparent resin 125a.

As described above, in the present invention, if there is a member that supports the wiring, the member can be used as the base material of the wiring substrate. The wiring substrate can also be configured by using a part of sealant 125 as the base material of the wiring substrate and forming the wiring on the base material as described above.

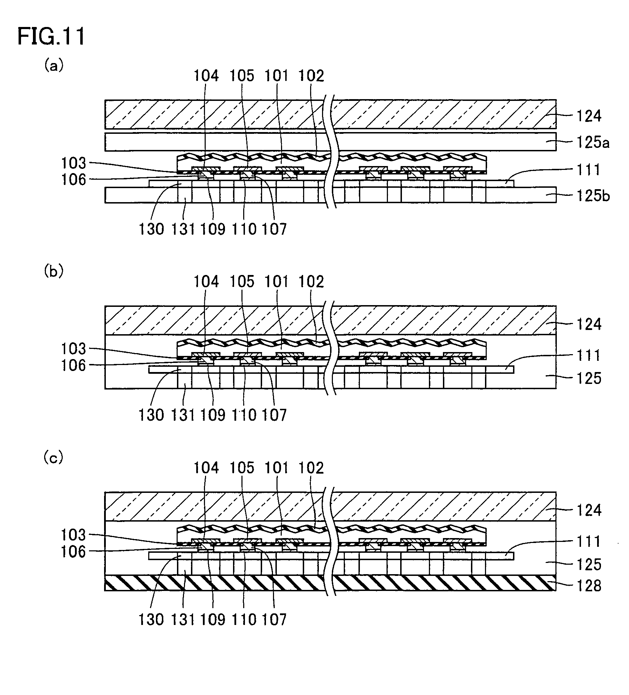

Figs. 11(a) to (c) show schematic cross-sectional views illustrating a manufacturing process of still another example of the method for manufacturing the solar cell module of the present invention. In this method, the solar cell module is **characterized in that** the wiring substrate has a through hole 130 penetrating from one surface to the other surface of insulating substrate 111 of the wiring substrate, and in addition, second transparent resin 125b placed on the surface of the wiring substrate opposite to the side where the solar cell is placed has a through hole 131 penetrating from one surface to the other surface of second transparent resin 125b, and the opening of through hole 130 is at least partially overlapped with the opening of through hole 131. This method is effective in automating a step of sealing the solar cell.

In this method, first, as shown in Fig. 11(a), second transparent resin 125b having through hole 131 is placed at a prescribed position of the laminator (not shown) having a vacuum stick function, and the wiring substrate having through hole 130 is placed on second transparent resin 125b. At this time, the opening of through hole 131 of second transparent resin 125b is at least partially overlapped with the opening of through hole 130 of insulating substrate 111 of the wiring substrate.

Next, the solar cell is arranged on the wiring substrate in accordance with the alignment mark by using an automated cell transport mechanism and the like, and as a result of vacuum stick through a hole that couples through hole 130 and through hole 131, the solar cell is fixed with high accuracy such that n electrode 106 of the solar cell is placed on wiring for the n type 109 of the wiring substrate and p electrode 107 of the solar cell is placed on wiring for the p type 110 of the wiring substrate.

It is preferable to form the alignment mark on at least one of the wiring substrate and the solar cell, and it is more preferable to form the alignment mark on one surface or both surfaces of the solar cell. When insulating substrate 111 of the wiring substrate and second transparent resin 125b have a certain level of light permeability, positioning with higher accuracy becomes possible by recognizing the alignment mark from the back surface of the solar cell through insulating substrate 111 and second transparent resin 125b, considering the dimensional error of silicon substrate 101 and various errors in the positional accuracy of the electrode of the solar cell and the like.

It is noted that the alignment mark can be recognized, for example, by using a method of visually recognizing the alignment mark from the above, a method of recognizing the alignment mark with a camera and the like, a method of recognizing the alignment mark with a light recognition sensor placed at a device such as the laminator, and the like.

In addition, the shape of the alignment mark is not particularly limited, and can be freely selected from a shape such as a cross shape, a round shape and a rhombus shape.

Next, as shown in Fig. 11(b), first transparent resin 125a and second transparent resin 125b are press-bonded, for example, by vacuum press-bonding and the like to form sealant 125, and the solar cell is wrapped in and sealed into sealant 125. Thereafter, as shown in Fig. 11(c), protective sheet 128 is placed on the back surface of sealant 125, and thus, the solar cell module is fabricated.

In addition, by measuring the resistance value between wiring for the n type 109 and wiring for the p type 110 of the wiring substrate after the solar cell is placed on the wiring substrate and before the step of press-bonding first transparent resin 125a and second transparent resin 125b, a short circuit due to misalignment and the like of the solar cell can be found at an early stage. Therefore, the measurement after placement and before press-bonding is preferable. If a short circuit is occurring due to misalignment of the solar cell, the position of the solar cell may only be corrected after the vacuum stick of the solar cell is temporarily stopped. If the misalignment is not still corrected, there is a high possibility that the solar cell itself has a problem, and thus, the solar cell may only be eliminated. Other than the above, a crack in the solar cell can also be found at an early stage by an EL (Electro Luminescence) inspection and the like. As described above, by measuring the resistance value between wiring for the n type 109 and wiring for the p type 110 of the wiring substrate after the solar cell is placed on the wiring substrate and before the step of press-bonding first transparent resin 125a and second transparent resin 125b, the poor properties and poor appearance of the solar cell can be found automatically at an early stage. Therefore, it is more likely to enhance the production efficiency and the yield of the solar cell module.

In addition, since insulating substrate 111 of the wiring substrate and second transparent resin 125b on the wiring substrate side have through holes 130 and 131, respectively, a part of thermally-deformed sealant 125 reaches an interface between the solar cell and the wiring substrate. As described above, the secondary effect can also be expected, that the use of the hole that couples through hole 130 and through hole 131 as an adhering portion can also contribute to enhancement of the adhesion strength of both the solar cell and the wiring substrate. Through holes 130 and 131 may have any shape, respectively, and can be, for example, a dot-shaped or strip-shaped hole. It is desirable that through holes 130 and 131 have a size and width allowing the inflow of the appropriate amount of sealant 125, such that uniform and excellent contact between the electrode of the solar cell and the wiring of the wiring substrate is maintained.

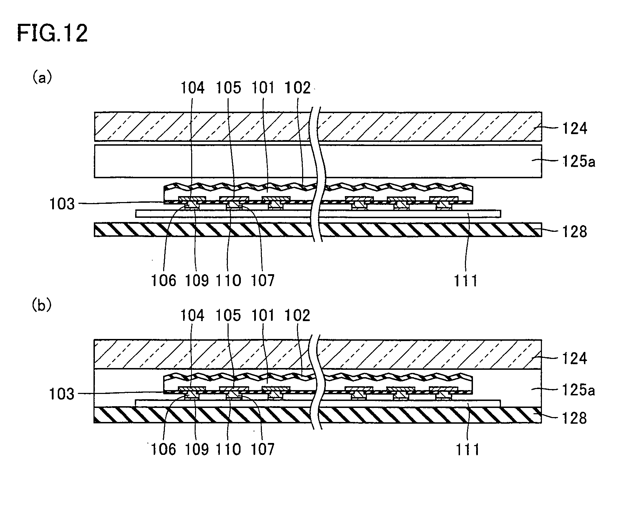

Figs. 12(a) and (b) show schematic cross-sectional views illustrating a manufacturing process of another example of the method for manufacturing the solar cell module of the present invention by using the solar cell having the configuration shown in Fig. 1. First, as shown in Fig. 12(a), n electrode 106 of the solar cell is placed on wiring for the n type 109 formed on insulating substrate 111 serving as the base material of the wiring substrate, and p electrode 107 of the solar cell is placed on wiring for the p type 110, and thus, the solar cell is placed on the wiring substrate.

Next, first transparent resin 125a is placed only on the surface of the solar cell opposite to the side where the wiring substrate is placed.

Then, first transparent resin 125a is subjected to heat treatment while being press-bonded to the solar cell, and the wiring substrate and the solar cell are sealed into first transparent resin 125a and cured. As a result, as shown in Fig. 12(b), the solar battery in which the solar cell is placed on the wiring substrate is sealed into first transparent resin 125a, and thus, the solar cell module of the present invention is fabricated.

Also in the solar cell module of the present invention having the configuration shown in Fig. 12(b), the solar cell is strongly press-bonded to the wiring substrate in first transparent resin 125a, and the press-bonding between n electrode 106 of the solar cell and wiring for the n type 109 of the wiring substrate as well as the press-bonding between p electrode 107 of the solar cell and wiring for the p type 110 of the wiring substrate are each strengthened. As a result, excellent electrical connection can be obtained between the electrodes of the solar cell and the wirings of the wiring substrate.

As described above, in the solar cell module of the present invention, the electrode of the solar cell is brought into direct contact with the wiring of the wiring substrate by the mechanical and physical press-bonding power resulting from the fixing power of sealant 125. It has already been confirmed that the adequate electrical properties that are equal to or better than those obtained when the conductive material such as solder and conductive paste is used to connect the electrode of the solar cell and the wiring of the wiring substrate can be obtained and the sufficiently excellent reliability can also be ensured.

In addition, in the present invention, since the solar cell is placed such that the electrode of the solar cell comes into direct contact with the upper portion of the wiring of the wiring substrate, the step of wiring by using the reflow and the like, the step of applying the adhesive to the solar cell and the wiring substrate, and the number of the members used can be reduced, respectively. Therefore, easy manufacturing of the solar cell module becomes possible, as compared with the prior art.

Furthermore, in the present invention, since the step of melting the solder or the conductive paste and the step of drying the adhesive is not essential, the solar cell module can be manufactured at a low temperature, and in addition, occurrence of warping and misalignment of the solar cell due to thermal expansion, thermal contraction and the like of the solar cell can be suppressed. Accordingly, in the present invention, not only manufacturing of the solar cell module at a low temperature but also reduction in the thickness and increase in the size of the solar cell can be achieved, and thus, significant reduction of cost can be accomplished.

It is noted that, in the present invention, the solar cell is preferably a back electrode type solar cell formed by placing both of the n electrode and the p electrode on one surface, in particular only on the back surface of the solar cell. The back electrode type solar cell includes a so-called back contact cell and an MWT (Metal Wrap Through) cell. In the present invention, however, the solar cell is not limited to the back electrode type solar cell, but is also applicable to a double-sided electrode type solar cell in which a transparent plastic film is used for insulating substrate 111 of the wiring substrate and electrodes are provided on each of the light receiving surface and the back surface.

In addition, when the back electrode type solar cell is used as the solar cell, the n electrode and the p electrode are formed adjacent to each other at a prescribed spacing on the back surface of the semiconductor substrate such as the silicon substrate. The spacing between the n electrode and the p electrode may be set to, for example, hundreds of micrometers to several millimeters. In some cases, in order to obtain more excellent properties, the spacing between the n electrode and the p electrode may be set to several micrometers to tens of micrometers, or may be set to a very minute pattern. In such a case, when the conductive material such as the solder and the conductive paste is used to connect the electrode of the back electrode type solar cell and the wiring of the wiring substrate, the conductive material may possibly form a bridge between the n electrode and the p electrode of the back electrode type solar cell in the step of applying the conductive material to the electrode of the solar cell and the wiring of the wiring substrate or in the step of welding, which may cause a short circuit. In addition, when the adhesive is used to bond the solar cell and the wiring substrate, it is quite conceivable that the adhesive may overflow or adhere to the interface between the electrode of the solar cell and the wiring of the wiring substrate, which may cause poor electrical contact. In the present invention, however, these risks can be avoided.

In addition, in the present invention, since a projection and the like formed by the solder, the conductive paste, the adhesive and the like can be lessened, a crack in the solar cell during the step of assembling the solar cell module can be reduced.

It is noted that the above methods shown in Figs. 8 to 12 may be used alone, or a combination of two or more methods may be used.

### Example

While the present invention will be described in more detail hereinafter in Examples, the present invention is not limited to these Examples.

### (Example 1)

First, back junction type solar cell 100 having the form shown in Fig. 1 was prepared. The light receiving surface and the back surface of silicon substrate 101 of solar cell 100 had a square shape having one side of 100 mm, and strip-shaped n electrode 106 and p electrode 107 were alternately arranged and formed in the shape shown in Fig. 3 (a) on the back surface of silicon substrate 101. The thickness of silicon substrate 101 can be set to about 100 to 500 µm (in the present example, 200 µm), and according to the present invention, the thickness of silicon substrate 101 can also be reduced to 100 µm or less.

Next, as shown in Fig. 1, the wiring made of copper such as wiring for the n type 109 and wiring for the p type 110 was transferred to insulating substrate 111 formed of the polyimide film, and thus, wiring substrate 200 was fabricated. The wiring pattern of wiring substrate 200 was such that sixteen solar cells 100 were able to be electrically connected in series as shown in Fig. 6.

Then, as shown in Fig. 6, solar cell 100 was placed in position on wiring substrate 200 in accordance with the alignment mark formed on solar cell 100 in advance, and thus, the solar battery having the form shown in Fig. 1 in which solar cell 100 was placed on wiring substrate 200 was fabricated. N electrode 106 of the solar cell was placed on wiring for the n type 109 of the wiring substrate, and p electrode 107 of the solar cell was placed on wiring for the p type 110 of the wiring substrate.

Next, as shown in Fig. 8(a), transparent substrate 124 made of glass, first transparent resin 125a made of the ethylene vinyl acetate resin, the solar cell fabricated in the above, second transparent resin 125b made of the ethylene vinyl acetate resin, and protective sheet 128 were put into the laminator in the order in which they appeared, and vacuum press-bonding of first transparent resin 125a and second transparent resin 125b was carried out. A sheet formed by sandwiching an aluminum foil between the PET films was used as protective sheet 128. In addition, the vacuum press-bonding was carried out by keeping first transparent resin 125a and second transparent resin 125b at 130°C for five minutes during vacuum evacuation.

Then, after the vacuum press-bonding, first transparent resin 125a and second transparent resin 125b were heated at 145°C for 40 minutes. Thereby, first transparent resin 125a and second transparent resin 125b were thermally cured and integrated to form sealant 125, and in addition, the solar cell was press-bonded to the wiring substrate by the securing power of sealant 125, as shown in Fig. 8(b). As a result, the solar battery in which the solar cell was placed on the wiring substrate was sealed into sealant 125, and thus, the solar cell module having the form shown in Fig. 7 was completed.

### (Example 2)

First, as shown in Fig. 2, the solar battery was formed by placing one solar cell 100 on wiring substrate 200.

In this solar battery, as shown in Fig. 2, solar cell 100 was provisionally attached onto wiring substrate 200 with fixing tape 300 that is a transparent viscous adhesive tape, and n electrode 106 of solar cell 100 came into direct contact with the upper portion of wiring for the n type 109 of wiring substrate 200, and p electrode 107 of solar cell 100 came into direct contact with the upper portion of wiring for the p type 110 of wiring substrate 200.

Then, the initial F. F of the solar battery fabricated in Example 2 was measured. The result thereof is shown in Table 1. It is noted that Table 1 shows the initial F. F of the solar cell module in Example 2 fabricated as will be described later, in addition to the initial F. F of the solar battery fabricated in Example 2, and furthermore, Table 1 shows the rate of change of the initial F. F of the solar cell module in Example 2 with respect to the initial F. F of the solar battery fabricated in Example 2.

Next, the solar battery fabricated as described above was sealed into sealant 125 as shown in Fig. 9(b), and thus, the solar cell module was fabricated.

As shown in Fig. 9(b), this solar cell module was configured such that one solar battery in which the solar cell was provisionally attached onto the wiring substrate with above fixing tape 300 was sealed into sealant 125 between transparent substrate 124 and protective sheet 128.

In addition, a white plate thermally-treated glass substrate was used as transparent substrate 124, the ethylene vinyl acetate resin was used as sealant 125, and the sheet having a configuration in which the aluminum film was sandwiched between the PET films was used as protective sheet 128. Moreover, the butyl rubber tape was affixed to the portion where it is difficult to bring protective sheet 128 into close contact, at the end face of the solar cell module, and protective sheet 128 was completely brought into close contact with sealant 125.

Then, the initial F. F of the solar cell module having the above configuration was measured. The result thereof is shown in Table 1.

In addition, the maximum output was measured after 2139 hours elapsed since the solar cell module having the above configuration that was separately fabricated as in Example 2 was left under the atmosphere of 85°C and 85% RH for a long time. The result thereof is shown in Table 2. It is noted that, in Table 2, the maximum output of the solar cell module after 2139 hours elapsed is indicated by the rate of change with respect to the initial maximum output of the above solar cell module before left.

Furthermore, the solar cell module having the above configuration that was separately fabricated as in Example 2 was left under the atmosphere of the temperature change between -40°C and 85°C, and the maximum output of the solar cell module was measured after 283 cycles elapsed, with -40°C → 85°C →-40°C set as one cycle.

The result thereof is shown in Table 3. It is noted that, in Table 3, the maximum output of the solar cell module after 283 cycles elapsed is indicated by the rate of change with respect to the initial maximum output of the above solar cell module before left.

### (Comparative Example 1)

Except that wiring for the n type 109 of wiring substrate 200 and n electrode 106 of solar cell 100 shown in Fig. 2 were welded with solder, and wiring for the p type 110 of wiring substrate 200 and p electrode 107 of solar cell 100 were welded with solder, the solar battery and the solar cell module formed by sealing the solar battery with sealant 125 were fabricated as in Example 2, respectively.

Then, the initial F. F of each of the solar battery and the solar cell module in Comparative Example 1 was measured. The result thereof is shown in Table 1.

### (Comparative Example 2)

Except that an interconnector was connected to one solar cell 100 without using wiring substrate 200, the solar cell and the solar cell module formed by sealing the solar cell with sealant 125 were fabricated as in Example 2, respectively.

Then, the initial F. F of each of the solar battery and the solar cell module in Comparative Example 2 was measured. The result thereof is shown in Table 1.

**[Table 1]**

| | Solar Cell Complex | Solar Cell Module | Rate of Change |
|---|---|---|---|
| Example 2 | 0.778 | 0.792 | 1.8% |
| Comparative Example 1 | 0.786 | 0.794 | 1.0% |
| Comparative Example 2 | 0.765 | 0.764 | -0.1% |

**[Table 2]**

| Time Period for which Solar Cell Module was Left | Initial | 2139 Hours |
|---|---|---|
| Example 2 | 0.0% | -0.9% |

**[Table 3]**

| Number of Cycles | Initial | 283 Cycles |
|---|---|---|
| Example 2 | 0.0% | 0.4% |

As shown in Table 1, in Example 2, the rate of change of the initial F. F of the solar cell module with respect to the initial F. F of the solar cell complex was +1.8% and rose by +0.8% as compared with Comparative Example 1. This indicates that, because of the fixing power of sealant 125, wiring for the n type 109 of the wiring substrate mechanically and physically comes into close contact with n electrode 106 of the solar cell without any void, and wiring for the p type 110 of the wiring substrate mechanically and physically comes into close contact with p electrode 107 of the solar cell without any void, and thus, more excellent electrical contact is obtained than that obtained by welding with solder.

In addition, as shown in Table 1, comparing Example 2 and Comparative Example 2, the rate of change of the initial F. F of the solar cell module with respect to the initial F. F of the solar cell complex rose by +1.9%. This indicates that the use of the wiring substrate can lead to significant reduction in the conductor resistance of the wiring generated at the solar cell.

Furthermore, as shown in Tables 2 and 3, in Example 2, the rate of change of the maximum output after left with respect to the initial maximum output before left was within 1% in both of the case where the solar cell module was left under the atmosphere of 85°C and 85% RH for a long time and the case where the solar cell module was left under the atmosphere of the temperature changed over a plurality of cycles, with -40°C → 85°C → -40°C set as one cycle. Therefore, it was also confirmed that the solar cell module had excellent reliability.

In the solar cell module fabricated as described above, the electrode of the solar cell is brought into direct contact with the wiring of the wiring substrate by mechanical and physical press-bonding resulting from the fixing power of sealant 125, and it can be confirmed that the adequate electrical properties that are equal to or better than those obtained when the conductive material such as solder and conductive paste is used to connect the electrode of the solar cell and the wiring of the wiring substrate can be obtained and the sufficiently excellent reliability can also be ensured.

In addition, in the present invention, since the solar cell is placed such that the electrode of the solar cell comes into direct contact with the upper portion of the wiring of the wiring substrate, the step of wiring by using the reflow and the like, the step of applying the adhesive to the solar cell and the wiring substrate, and the number of the members used can be reduced, respectively. Therefore, easy manufacturing becomes possible, as compared with the prior art. Furthermore, since the solar cell module does not undergo the step of melting the solder and the conductive paste and the step of drying the adhesive, the solar cell module can be manufactured at a low temperature.

It should be understood that the embodiments and the examples disclosed herein are illustrative and not limitative in any respect. The scope of the present invention is defined by the terms of the claims, rather than the above description, and is intended to include any modifications within the scope and meaning equivalent to the terms of the claims.

### INDUSTRIAL APPLICABILITY

According to the present invention, there can be provided a solar cell module that can be readily manufactured at a low temperature and has excellent electrical properties and reliability, and a method for manufacturing the solar cell module.

## Claims

1. A solar cell module, comprising: a wiring substrate (200) having a base material (111) and a wiring (109, 110) formed on said base material (111); and a solar cell (100) having an electrode (106, 107) electrically connected to the wiring (109, 110) of said wiring substrate (200),
said wiring (109, 110) being electrically connected to said electrode (106, 107) by bringing said wiring (109, 110) into direct contact with said electrode (106, 107).

2. The solar cell module according to claim 1, wherein
a through hole (130, 131) penetrating from one surface to the other surface of said base material (111) is formed in said wiring substrate (200).

3. The solar cell module according to claim 1, wherein
said base material (111) of said wiring substrate (200) is made of a transparent resin.

4. The solar cell module according to claim 1, comprising a sealant (125, 125a, 125b) sealing said wiring substrate (200) and said solar cell (100).

5. The solar cell module according to claim 4, wherein
said sealant (125, 125a, 125b) includes at least one type of transparent resin selected from the group consisting of an ethylene vinyl acetate resin, an epoxy resin, an acrylic resin, a urethane resin, an olefin-based resin, a polyester resin, a silicone resin, a polystyrene resin, a polycarbonate resin, and a rubber-based resin.

6. The solar cell module according to claim 1, wherein
said solar cell (100) is a back electrode type solar cell (100).

7. The solar cell module according to claim 1, wherein
said solar cell (100) and said wiring substrate (200) are fixed by a fixing member (300).

8. The solar cell module according to claim 7, wherein
said fixing member (300) couples a light receiving surface of said solar cell (100) and a surface of said wiring substrate (200) on a side where said solar cell (100) is placed.

9. The solar cell module according to claim 7, wherein
said fixing member (300) couples a back surface of said solar cell (100) and a surface of said wiring substrate (200) on a side where said solar cell (100) is placed.

10. The solar cell module according to claim 7, wherein
said fixing member (300) is at least one type selected from the group consisting of an adhesive tape, a viscous adhesive tape, an adhesive, and a viscous adhesive agent.

11. The solar cell module according to claim 7, wherein
said fixing member (300) is made of at least one of a transparent resin and an ultraviolet curing resin.

12. A solar cell module, comprising: a wiring substrate (200) having a base material (111) and a wiring (109, 110) formed on said base material (111); and a solar cell (100) having an electrode (106, 107) electrically connected to the wiring (109, 110) of said wiring substrate (200),
said wiring (109, 110) being electrically connected to said electrode (106, 107) by bringing said wiring (109, 110) into direct contact with said electrode (106, 107),
said solar cell module comprising
a sealant (125, 125a, 125b) sealing, said wiring substrate (200) and said solar cell (100), and
said sealant (125, 125a, 125b) being placed on only one surface of said solar cell (100) and press-bonded to said solar cell (100) to seal said wiring substrate (200) and said solar cell (100).

13. A method for manufacturing the solar cell module as recited in claim 1, comprising the steps of:
placing said solar cell (100) on said wiring substrate (200);
press-bonding a first transparent resin (125a) placed on a surface of said solar cell (100) opposite to a side where said wiring substrate (200) is placed and a second transparent resin (125b) placed on a surface of said wiring substrate (200) opposite to a side where said solar cell (100) is placed; and
heating said first transparent resin (125a) and said second transparent resin (125b) after said press-bonding.

14. The method for manufacturing the solar cell module according to claim 13,
wherein
said first transparent resin (125a) and said second transparent resin (125b) are press-bonded by vacuum press-bonding.

15. The method for manufacturing the solar cell module according to claim 13,
wherein
a through hole (130, 131) penetrating from one surface to the other surface of said base material (111) is formed in said wiring substrate (200), and the through hole (130, 131) penetrating from one surface to the other surface of said second transparent resin (125b) is formed in said second transparent resin (125b).

16. The method for manufacturing the solar cell module according to claim 13, comprising the step of
fixing said solar cell (100) and said wiring substrate (200) by a fixing member (300).

17. The method for manufacturing the solar cell module according to claim 16,
wherein
said fixing member (300) is placed to couple a light receiving surface of said solar cell (100) and a surface of said wiring substrate (200) on the side where said solar cell (100) is placed.

18. The method for manufacturing the solar cell module according to claim 16,
wherein
said fixing member (300) is placed to couple a back surface of said solar cell (100) and a surface of said wiring substrate (200) on the side where said solar cell (100) is placed.

19. The method for manufacturing the solar cell module according to claim 16,
wherein
said fixing member (300) is at least one type selected from the group consisting of an adhesive tape, a viscous adhesive tape, an adhesive, and a viscous adhesive agent.

20. The method for manufacturing the solar cell module according to claim 16,
wherein
said fixing member (300) is made of at least one of a transparent resin and an ultraviolet curing resin.

21. A method for manufacturing the solar cell module as recited in claim 1, comprising the steps of:
placing said solar cell (100) on said wiring substrate (200) having said base material (111) made of a transparent resin;
press-bonding said base material (111) of said wiring substrate (200) and a first transparent resin (125a) placed on a surface of said solar cell (100) opposite to a side where said wiring substrate (200) is placed; and
heating said base material (111) and said first transparent resin (125a) after said press-bonding.

22. The method for manufacturing the solar cell module according to claim 21, comprising the step of
fixing said solar cell (100) and said wiring substrate (200) by a fixing member (300).

23. The method for manufacturing a solar cell module according to claim 22,
wherein
said fixing member (300) is placed to couple a light receiving surface of said solar cell (100) and a surface of said wiring substrate (200) on the side where said solar cell (100) is placed.

24. The method for manufacturing the solar cell module according to claim 22,
wherein
said fixing member (300) is placed to couple a back surface of said solar cell (100) and a surface of said wiring substrate (200) on the side where said solar cell (100) is placed.

25. The method for manufacturing the solar cell module according to claim 22,
wherein
said fixing member (300) is at least one type selected from the group consisting of an adhesive tape, a viscous adhesive tape, an adhesive, and a viscous adhesive agent.

26. The method for manufacturing the solar cell module according to claim 22,
wherein
said fixing member (300) is made of at least one of the transparent resin and an ultraviolet curing resin.
